# EUROPEAN PATENT SPECIFICATION

(11) **EP 2 617 793 B1**
(45) Date of publication and mention of the grant of the patent: **05.08.2020**
(21) Application number: 11825209.7
(22) Date of filing: 14.09.2011
(51) Int. Cl.: C09J 7/38, C09J 5/06, C09J 201/00, C09J 133/02, C09J 133/10, C09J 183/04, B32B 38/10, C08G 77/20, C08L 83/04, H01L 21/02, H01L 21/683

(54) **PRESSURE-SENSITIVE ADHESIVE COMPOUND, PRESSURE-SENSITIVE ADHESIVE TAPE, AND WAFER TREATMENT METHOD**
DRUCKEMPFINDLICHER VERBUNDKLEBSTOFF, DRUCKEMPFINDLICHES KLEBEBAND UND WAFERBEARBEITUNGSVERFAHREN
COMPOSÉ ADHÉSIF AUTOCOLLANT, BANDE ADHÉSIVE AUTOCOLLANTE, ET PROCÉDÉ DE TRAITEMENT DE TRANCHE

(30) Priority: 16.09.2010 JP 2010208286
(43) Date of publication of application: 24.07.2013
(73) Proprietor: Sekisui Chemical Co., Ltd., Osaka-shi, Osaka 530-0047 (JP)
(72) Inventor: TONEGAWA Toru, Mishima-gun, Osaka 618-0021 (JP); ASAO Takahiro, Mishima-gun, Osaka 618-0021 (JP); SUMII Yuichi, Mishima-gun, Osaka 618-0021 (JP); NOMURA Shigeru, Mishima-gun, Osaka 618-0021 (JP); FUKUOKA Masateru, Mishima-gun, Osaka 618-0021 (JP); SUGITA Daihei, Mishima-gun, Osaka 618-0021 (JP)
(74) Representative: Cabinet Beau de Loménie
(86) International application number: PCT/JP2011/071004
(87) International publication number: WO 2012/036209

(56) References cited:
- EP-A1- 2 033 996
- EP-A2- 0 298 448
- WO-A1-2009/144985
- JP-A- 1 249 878
- JP-A- 10 306 274
- JP-A- 2000 044 890
- JP-A- 2004 083 646
- JP-A- 2009 132 867
- JP-A- 2009 245 989
- JP-A- 2010 132 755

## Description

### TECHNICAL FIELD

The present invention relates to an adhesive composition which has high initial adhesion and can strongly fix an adherend, while can be easily peeled off by light irradiation even after undergoing a high-temperature process at 200°C or higher. The present invention also relates to an adhesive tape produced from the adhesive composition, and a wafer treatment method using the adhesive composition.

### BACKGROUND ART

In the manufacture of semiconductors, a tape for semiconductor processing is applied in order to allow a semiconductor to be handled easier and to prevent it from cracking during processing. For example, when a thick wafer cut from a high purity silicon monocrystal or the like is ground into a thin wafer having a predetermined thickness, the thick wafer is taped to a support plate to be reinforced with a double side adhesive tape. Also, when the thin wafer ground to a predetermined thickness is diced into IC chips, an adhesive tape called dicing tape is used.

Tapes for semiconductor processing are required to be highly adhesive enough to fix a semiconductor strongly during a processing, and also required to be peeled off without damaging the semiconductor after the processing. In the light of this, Patent Literature 1 discloses an adhesive tape containing a photocurable adhesive, which is cured by irradiation of light (e.g. ultraviolet rays) and thereby becomes less adhesive. Such an adhesive tape can securely fix a semiconductor during a processing and can be easily peeled off by irradiation of ultraviolet rays and the like.

Even such an adhesive tape containing a photocurable adhesive has a problem that when it is used in a semiconductor processing including a heating process, the adhesion is not reduced sufficiently by irradiation of ultraviolet rays and the like and the tape may not be peeled off. This is considered to be because the heating enhances the adhesion of the adhesive.

To overcome the problem, Patent Literature 2 discloses a tape containing a photocurable adhesive which contains an acrylic polymer as a main component and a (meth)acrylic oligomer having a radically-polymerizable unsaturated bond as a bleeding agent. It says that such a bleeding agent has high compatibility with the photocurable adhesive and does not reduce the adhesion at room temperature, while it has lower compatibility with the photocurable adhesive under heating and bleeds out so that the tape can be easily peeled off.

However, recent semiconductor processing increasingly needs a high-temperature process at 200°C or higher such as a CVD process and a reflow soldering process. There is a problem that after undergoing such a high-temperature process, even the photocurable adhesive disclosed in Patent Literature 2 burns and sticks to the adherend, or, if it does not, becomes extremely difficult to be peeled off.

### CITATION LIST

### Patent Literature

Patent Literature 1: Japanese Kokai Publication No. Hei-05-32946 (JP-A H5-32946)
Patent Literature 2: Japanese Kokai Publication No. 2008-280505 (JP-A 2008-280505)

An adhesive composition should have high initial adhesion and fix an adherend strongly, while allowing easily peeling off by light irradiation even after undergoing a high-temperature process at 200°C or higher.

Each of EP 2 033 996 A1, WO 2009/144985 A and EP 0 298 448 A2 shows an adhesive composition including an adhesive component, a photoinitiator, and a silicone compound containing a functional group that is crosslinkable with the adhesive component.

Adding a silicone compound, which is a bleeding agent, to an adhesive, which silicone compound is especially excellent in heat resistance among bleeding agents, may prevent the adhesive from burning even after the adhesive undergoes a high-temperature process at 200°C or higher and to bleed out on the interface of the adherend at peeling so as to facilitate peeling. However, when the silicone compound is added, there is a problem that the semiconductor wafer is contaminated by the bled silicone compound, and thereby a washing is required.

When a silicone compound containing a functional group that is crosslinkable with the adhesive component is used as a bleeding agent, the adhesive can be easily peeled off even after undergoing a high-temperature process at 200°C or higher and does not cause the contamination of the semiconductor wafer.

### SUMMARY OF INVENTION

The adhesive composition of the present invention is defined in claim 1 and contains an adhesive component.

The adhesive component is a curable adhesive component.

Non-curable adhesive components have a functional group that is reactable with the silicone compound by light irradiation, like rubber adhesives, acrylic adhesives, vinylalkylether adhesives, silicone adhesives, polyester adhesives, polyamide adhesives, urethane adhesives, and styrene-diene block copolymer adhesives, in particular adhesives which contain a (meth)acrylic group are suitable.

The curable adhesive component is a photocurable adhesive component containing an alkyl (meth)acrylate polymerizable polymer having a radically-polymerizable unsaturated bond in a molecule.

Such a photocurable adhesive is uniformly and quickly crosslinked as a whole by light irradiation to be integrated. Thus, the elasticity is significantly increased by curing, resulting in substantial reduction in adhesion.

The polymerizable polymer is obtained by, for example, previously preparing a (meth)acrylic polymer (hereinafter, also referred to as "functional group-containing (meth)acrylic polymer") having a functional group in a molecule and reacting it with a compound (hereinafter, also referred to as "functional group-containing unsaturated compound) containing a functional group that is reactable with the above functional group and a radically-polymerizable unsaturated bond in a molecule.

The functional group-containing (meth)acrylic polymer is prepared as a polymer which has adhesion at normal temperature by copolymerizing an alkyl acrylate and/or alkyl methacrylate containing an alkyl group generally having 2 to 18 carbon atoms, as a main monomer, with a functional group-containing monomer and optionally another copolymerizable modifier monomer using a usual method, as in the case of an usual (meth)acrylic polymer. The functional group-containing (meth)acrylic polymer generally has a weight-average molecular weight of about 200000 to 2000000.

Examples of the above functional group-containing monomer include carboxyl-containing monomers such as acrylic acid and methacrylic acid; hydroxyl-containing monomers such as hydroxyethyl acrylate and hydroxyethyl methacrylate; epoxy-containing monomers such as glycidyl acrylate and glycidyl methacrylate; isocyanate-containing monomers such as isocyanate ethyl acrylate and isocyanate ethyl methacrylate; and amino-containing monomers such as aminoethyl acrylate and aminoethyl methacrylate.

Examples of another copolymerizable modifier monomer include various kinds of monomers used for usual (meth)acrylic polymers such as vinyl acetate, acrylonitrile, and styrene.

As the functional group-containing unsaturated compound to be reacted with the above functional group-containing (meth)acrylic polymer, the same functional group-containing monomers as those described above can be used in accordance with the functional group of the functional group-containing (meth)acrylic polymer. For example, in the case that the functional group of the functional group-containing (meth)acrylic polymer is a carboxyl group, epoxy-containing monomers or isocyanate-containing monomers may be used; in the case that the functional group is a hydroxyl group, isocyanate-containing monomers may be used; in the case that the functional group is an epoxy group, carboxyl-containing monomers or amide-containing monomers such as acrylamide may be used; and in the case that the functional group is an amino group, epoxy-containing monomers may be used.

The alkyl (meth)acrylate polymerizable polymer having a radically-polymerizable unsaturated bond in a molecule may be used in combination with a polyfunctional oligomer or monomer.

The polyfunctional oligomer or monomer preferably has a molecular weight of 10000 or less, and more preferably has a molecular weight of 5000 or less and 2 to 20 radically-polymerizable unsaturated bonds in a molecule so that three-dimensional network can be formed efficiently in the adhesive layer by heating or irradiation of light. Examples of such preferable polyfunctional oligomer or monomer include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, and methacrylates of these compounds. The examples also include 1,4-butylene glycol diacrylate, 1,6-hexanediol diacrylate, polyethylene glycol diacrylate, commercialized oligoester acrylates and methacrylates of these compounds. These polyfunctional oligomers or monomers can be used alone or two or more of them can be used in combination.

The adhesive composition of the present invention contains a photoinitiator.

The photoinitiator may be one activated by irradiation of light having a wavelength of 250 to 800 nm. Examples thereof include photoradical polymerization initiators including acetophenone derivative compounds such as methoxyacetophenone; benzoin ether compounds such as benzoin propyl ether and benzoin isobutyl ether; ketal derivative compounds such as benzyl dimethyl ketal and acetophenone diethyl ketal; phosphine oxide derivative compounds; bis(η5-cyclopentadienyl)titanocene derivative compounds, benzophenone, Michler's ketone, chlorothioxanthone, dodecylthioxanthone, dimethylthioxanthone, diethylthioxanthone, α-hydroxycyclohexyl phenyl ketone, and 2-hydroxymethylphenylpropane. These photoinitiators may be used alone or two or more of them may be used in combination.

A silicone compound (hereinafter, also referred to as simply "silicone compound A") containing a functional group that is crosslinkable with the above adhesive component is excellent in heat resistance and thus prevents the adhesive from burning even after the adhesive undergoes a high-temperature process at 200°C or higher. Also, it bleeds out on the interface of the adherend at peeling and thereby facilitates the peeling. Since the silicone compound has a functional group that is crosslinkable with the adhesive component, it reacts chemically with the adhesive component by irradiation with light at peeling and is incorporated thereinto. Thus, the adherend is not contaminated by the silicone compound. If one of the adherends is a support plate formed of glass, since the adhesive composition containing the silicone compound containing a functional group that is crosslinkable with the adhesive component has improved compatibility to the support plate, the effect of preventing adhesive residue on the wafer can be exhibited.

The silicone backbone of the silicone compound A is not particularly limited, and may be D form or DT form.

The silicone compound A preferably has the functional group at a side chain or terminus of the silicone backbone.

Especially, a silicone compound having a D-form backbone and a functional group that is crosslinkable with the adhesive component at a terminus is suitably used because such a silicone compound is more likely to have both high initial adhesion and peelability after a high-temperature process.

A functional group that is crosslinkable with a (meth)acrylic group is a functional group which has an unsaturated double bond. Specific examples thereof include a vinyl group, a (meth)acrylic group, an allyl group, and a maleimide group.

The functional group equivalent of the silicone compound A is not particularly limited. A preferable lower limit thereof is 1, and a preferable upper limit is 20. If the functional group equivalent is less than 1, the silicone compound A may not be sufficiently incorporated into the adhesive component when the adhesive composition to be obtained is cured. This may lead to contamination of the adherend, or insufficient peelability. If the equivalent is more than 20, adhesion may be insufficient. A more preferable upper limit is 10, and a more preferable lower limit is 2. A further preferable upper limit is 6.

The molecular weight of the silicone compound A is not particularly limited. A preferable lower limit is 300, and a preferable upper limit is 50000. If the molecular weight is less than 300, the adhesive composition to be obtained may have insufficient heat resistance. If the molecular weight is more than 50000, the silicone compound may be hard to be mixed with the adhesive component. A more preferable lower limit is 400, and a more preferable upper limit is 10000. A further preferable lower limit is 500, and a further preferable upper limit is 5000.

The method of synthesizing the silicone compound A is not particularly limited. Examples thereof include: a method in which a silicone resin having an SiH group is hydrosilylated with a vinyl compound containing a functional group that is crosslinkable with the adhesive component to introduce the functional group that is crosslinkable with the adhesive component to the silicone resin; and a method in which a siloxane compound and a siloxane compound containing a functional group that is crosslinkable with the adhesive component are subjected to a condensation reaction.

As for the silicone compound A, commercially available ones are, for example, silicone compounds having methacrylic groups at both termini such as X-22-164, X-22-164AS, X-22-164A, X-22-164B, X-22-164C, and X-22-164E, produced by Shin-Etsu Chemical Co., Ltd., silicone compounds having a methacrylic group at one terminus such as X-22-174DX, X-22-2426, and X-22-2475, produced by Shin-Etsu Chemical Co., Ltd., silicone compounds having an acrylic group such as EBECRYL350 and EBECRYL1360 produced by Daicel-Cytec Company Ltd., silicone compounds having an acrylic group such as AC-SQ TA-100 and AC-SQ SI-20 produced by Toagosei Co., Ltd. and silicone compounds having a methacrylic group such as MAC-SQ TM-100, MAC-SQ SI-20, and MAC-SQ HDM produced by Toagosei Co., Ltd..

Among these, silicone compounds having a (meth)acrylic group on a siloxane backbone represented by the following formulae (I), (II), or (III) is in the adhesive composition of claim 1 and these have very high heat resistance and are easy to bleed out from the adhesive composition because of the high polarity.

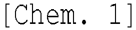

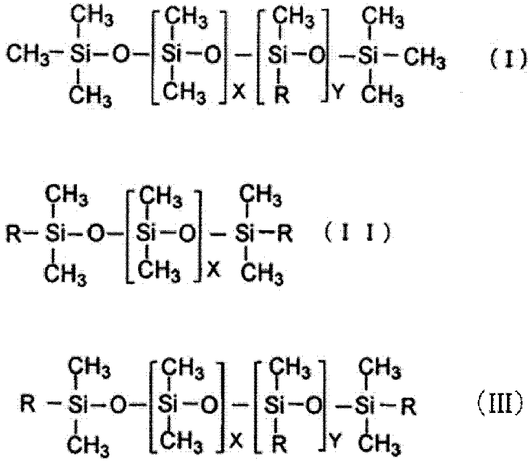

In the formulae, X and Y represent an integer from 0 to 1200, and R represents a functional group having an unsaturated double bond being a (meth)acrylic group.

Among the silicone compounds having a (meth)acrylic group on the siloxane backbone represented by the formulae (I), (II), or (III), commercially available ones are, for example, EBECRYL350 and EBECRYL1360 (in each of which, R is an acrylic group) produced by Daicel-Cytec Company, Ltd.

The amount of the silicone compound A is not particularly limited. A preferable lower limit thereof is 0.1% by weight, and a preferable upper limit thereof is 30% by weight. If the amount of the silicone compound A is less than 0.1% by weight, the adhesive composition may be unable to be peeled off from the adherend. If the amount is more than 30% by weight, the initial adhesion may not be provided. A more preferable lower limit of the amount is 0.2% by weight, and a more preferable upper limit is 20% by weight.

A preferable lower limit of the amount of the silicone compound A for 100 parts by weight of the adhesive component is 0.5 parts by weight, and a preferable upper limit is 40 parts by weight. If the amount of the silicone compound A is less than 0.5 parts by weight, the adhesion may not be reduced sufficiently even by light irradiation, and thereby the adhesive composition may not be peeled off from the adherend. If the amount is more than 40 parts by weight, the adherend may be contaminated by the compound. A more preferable lower limit of the amount is 1 part by weight, and a more preferable upper limit is 30 parts by weight.

The adhesive composition of the present invention may contain an inorganic filler.

The inorganic filler is preferably one selected from the group consisting of oxides of silicon, titanium, aluminum, calcium, boron, magnesium, and zirconia, and complexes thereof. Among these, silicon-aluminum-boron complex oxides, silicon-titanium complex oxides, and silica-titania complex oxides are more preferred because these have a similar physical property as silica, which is generally used as inorganic filler.

The average particle diameter of the inorganic filler is not particularly limited. A preferable lower limit thereof is 0.1 **µ**m, and a preferable upper limit is 30 **µ**m.

The amount of the inorganic filler is not particularly limited. A preferable lower limit thereof is 30 parts by weight, and a preferable upper limit is 150 parts by weight for 100 parts by weight of the adhesive component. A more preferable lower limit is 60 parts by weight, and a more preferable upper limit is 120 parts by weight.

The adhesive composition of the present invention may appropriately contain various polyfunctional compounds which are added to usual adhesives, such as isocyanate compounds, melamine compounds, and epoxy compounds in order to adjust the cohesive power. Also, the adhesive composition may contain a known additive such as an antistatic agent, a plasticizer, a resin, a surfactant, and a wax, and further may contain heat stabilizer and antioxidant in order to improve the stability of the adhesive.

The adhesive composition of the present invention may contain a gas generating agent that generates gas by light irradiation. When the adhesive composition containing such a gas generating agent is irradiated with light, the photocurable adhesive component is crosslinked and cured to increase the elasticity of the entire adhesive. Gas generated in such a stiff adhesive is discharged from the adhesive to the adhesive interface to peel off at least a part of the adhesive surface. In this manner, the adhesive composition is more easily peeled off.

The gas generating agent is not particularly limited, and may be, for example, an azide compound, an azo compound, ketoprofen, a tetrazole compound. Among these, ketoprofen and a tetrazole compound, which are excellent in heat resistance, are suitable.

The adhesive composition of the present invention has high initial adhesion, while can be easily peeled off by irradiation of light such as ultra violet rays. The adhesive composition is also excellent in heat resistance, and thus is also used in applications including a high-temperature process at 200°C or higher. For example, it can be used for fixing a wafer to a support plate in manufacturing process of TSV, or for temporarily fixing a wafer or a chip to a support plate in passing the wafer or the chip through a reflow oven.

The adhesive composition of the present invention can be used for various adherent products.

Examples thereof include adhesives, pressure-sensitive adhesives, coating materials, coating agents, and sealing agents which contain the adhesive composition of the present invention as a binder resin, and adhesive tapes which contain the adhesive composition of the present invention as an adhesive, such as single side adhesive tapes, double side adhesive tapes, and no-carrier tapes (no-backing tapes). The adhesive composition is especially suitable for tapes for fixing a support plate in a high-temperature treatment, tapes for fixing used in both a high-temperature treatment and back grinding, tapes for fixing used in both a high-temperature treatment and dicing, and tapes for temporarily fixing used in a high-temperature treatment of a singulated semiconductor chip.

The present invention includes an adhesive tape having an adhesive layer of the adhesive composition of the present invention on a substrate.

Examples of the substrate include a sheet produced from a transparent resin such as acryl, olefin, polycarbonate, vinyl chloride, ABS, polyethylene terephthalate (PET), polyethylene naphthalate (PEN), nylon, urethane, and polyimide, a sheet having a network structure, and a sheet having a pore.

The method for manufacturing the adhesive tape of the present invention is not particularly limited, and conventionally known methods can be used. Examples thereof include a method in which the adhesive and the like are applied on a substrate using a doctor knife, a spin coater, or the like.

The adhesive composition of the present invention is suitable as an adhesive used for fixing a wafer to a support plate in order to allow the wafer to be handled easier and to prevent it from cracking in processing of the wafer including a high-temperature process at 200°C or higher.

The present invention also include a wafer treatment method including: a step of fixing a support plate in which a wafer is fixed to a support plate with the adhesive composition of the present invention; a step of treating the wafer in which the surface of the wafer fixed to the support plate is subjected to a treatment including heating at 200°C or higher; and a step of peeling the support plate in which the wafer after the treatment is irradiated with light to cure the adhesive composition to peel off the support plate from the wafer.

The support plate is not particularly limited, and examples thereof include glass plates, silica glass plates, and stainless-steel plates.

The treatment including heating at 200°C or higher is not particularly limited, and may be, for example, chemical vapor deposition (CVD), reflow, and reactive ion etching (RIE).

### Advantageous Effect of Invention

According to the present invention, an adhesive composition which has high initial adhesion and can fix an adherend strongly, while can be peeled off by light irradiation even after undergoing a high-temperature process at 200°C or higher, an adhesive tape produced from the adhesive composition, and a wafer treatment method using the adhesive composition can be provided.

### BRIEF DESCRIPTION OF EMBODIMENT

In the following, the embodiment of the present invention is described more specifically based on, but not limited to, examples.

### (Example 1)

A reactor equipped with a thermometer, an agitator, and a condenser tube is prepared. The reactor is charged with 94 parts by weight of 2-ethylhexyl acrylate, 1 part by weight of acrylic acid, 5 parts by weight of 2-hydroxyethyl acrylate, 0.01 parts by weight of lauryl mercaptan, and 80 parts by weight of ethyl acetate. Then, the reactor was heated and reflux was initiated. After that, 0.01 parts by weight of 1,1-bis(t-hexylperoxy)-3,3,5-trimethylcyclohexane was added as a polymerization initiator to the reactor so that the polymerization was initiated under reflux. One hour after and two hours after initiation of the polymerization, 0.01 parts by weight of 1,1-bis(t-hexylperoxy)-3,3,5-trimethylcyclohexane was added. Four hours after the initiation, 0.05 parts by weight of t-hexylperoxy pivalate was added so as to continue the polymerization reaction. Then, eight hours after initiation of the polymerization, an acrylic copolymer having a solid content of 55% by weight and a weight average molecular weight of 600000 was obtained.

3.5 parts by weight of 2-isocyanatoethyl methacrylate was added to and reacted with 100 parts by weight of the resin solid content of the ethyl acetate solution containing the obtained acrylic copolymer. Then, 1 part by weight of a photoinitiator (Esacure One produced by Nihon Siber Hegner k.k.), 1 part by weight of a silicone compound containing a (meth)acrylic group (EBECRYL350, acryl equivalent: 2, produced by Daicel-Cytec Company, Ltd.), and 0.5 parts by weight of a polyisocyanate crosslinking agent (Coronate L45 produced by Nippon Polyurethane Industry Co., Ltd.) were added to 100 parts by weight of the resin solid content of the reacted ethyl acetate solution. Thus, an adhesive composition in ethyl acetate was prepared.

One side of a transparent polyethylene naphthalate film having a thickness of 50 µm was corona treated. The adhesive composition in ethyl acetate was applied to the corona-treated side of the film with a doctor knife such that the thickness of the coated composition after dried was 30 µm. Then, the applied solution was heated and dried at 110°C for 5 minutes. After that, the resulting product was allowed to stand for aging at 40°C for three days to provide an adhesive tape.

### (Example 2)

An adhesive composition and an adhesive tape were obtained in the same manner as in Example 1, except that the amount of the silicone compound containing a (meth)acrylic group was 1.5 parts by weight.

### (Example 3)

An adhesive composition and an adhesive tape were obtained in the same manner as in Example 1, except that the amount of the silicone compound containing a (meth)acrylic group was 2 parts by weight.

### (Example 4)

An adhesive composition and an adhesive tape were obtained in the same manner as in Example 1, except that the amount of the silicone compound containing a (meth)acrylic group was 8 parts by weight.

### (Example 5)

An adhesive composition and an adhesive tape were obtained in the same manner as in Example 1, except that the amount of the silicone compound containing a (meth)acrylic group was 10 parts by weight.

### (Example 6)

An adhesive composition and an adhesive tape were obtained in the same manner as in Example 1, except that the amount of the silicone compound containing a (meth)acrylic group was 20 parts by weight.

### (Example 7)

An adhesive composition and an adhesive tape were obtained in the same manner as in Example 1, except that the amount of the silicone compound containing a (meth)acrylic group was 30 parts by weight.

### (Example 8)

An adhesive composition and an adhesive tape were obtained in the same manner as in Example 3, except that EBECRYL1360 (acrylic equivalent: 6, produced by Daicel-Cytec Company, Ltd.) was used as the silicone compound containing a (meth)acrylic group in place of EBECRYL350 (acrylic equivalent: 2, produced by Daicel-Cytec Company, Ltd.).

### (Example 9)

An adhesive composition and an adhesive tape were obtained in the same manner as in Example 3, except that 20 parts by weight of ketoprofen was further added as a gas generating agent for 100 parts by weight of the resin solid content of the ethyl acetate solution containing the acrylic copolymer.

### (Example 10)

An adhesive composition and an adhesive tape were obtained in the same manner as in Example 5, except that 10 parts by weight of 5-m(aminophenyltetrazole) was further added as a gas generating agent for 100 parts by weight of the resin solid content of the ethyl acetate solution containing the acrylic copolymer.

### (Example 11)

An adhesive composition and an adhesive tape were obtained in the same manner as in Example 3, except that 20 parts by weight of Reolosil MT-10 (silica filler, produced by Tokuyama Corporation) was further added as an inorganic filler for 100 parts by weight of the resin solid content of the ethyl acetate solution containing the acrylic copolymer.

### (Example 12)

An adhesive composition and an adhesive tape were obtained in the same manner as in Example 3, except that 10 parts by weight of 5-m(aminophenyltetrazole) as a gas generating agent and 20 parts by weight of Reolosil MT-10 (silica filler, produced by Tokuyama Corporation) as an inorganic filler were further added for 100 parts by weight of the resin solid content of the ethyl acetate solution containing the acrylic copolymer.

### (Example 13)

An adhesive composition and an adhesive tape were obtained in the same manner as in Example 3, except that 10 parts by weight of sodium salt of bistetorazole as a gas generating agent and 20 parts by weight of Reolosil MT-10 (silica filler, produced by Tokuyama Corporation) as an inorganic filler were further added for 100 parts by weight of the resin solid content of the ethyl acetate solution containing the acrylic copolymer.

### (Example 14)

An adhesive composition and an adhesive tape were obtained in the same manner as in Example 3, except that 1 part by weight of a silicone compound containing a (meth)acrylic group (AC-SQ, containing a hydroxyl group and an acrylic group, produced by Toagosei Co., Ltd.), 1 part by weight of a photoinitiator (Esacure One produced by Nihon Siber Hegner k.k.), and 0.5 parts by weight of polyisocyanate crosslinking agent (Coronate L-45 produced by Nippon Polyurethane Industry Co., Ltd.) were mixed to provide an adhesive composition in ethyl acetate.

### (Example 15)

An adhesive composition and an adhesive tape were obtained in the same manner as in Example 1, except that the amount of the silicone compound containing a (meth)acrylic group was 0.5 parts by weight.

### (Comparative Example 1)

An adhesive composition and an adhesive tape were obtained in the same manner as in Example 1, except that the silicone compound containing a (meth)acrylic group was not added.

### (Comparative Example 2)

An adhesive composition and an adhesive tape were obtained in the same manner as in Example 6, except that the silicone compound containing a (meth)acrylic group was not added.

### (Comparative Example 3)

An adhesive composition and an adhesive tape were obtained in the same manner as in Example 1, except that 1 part by weight of an acrylic oligomer having no silicone backbone (NK Oligo U-324A, produced by Shin-Nakamura Chemical Co., Ltd.) was mixed in place of the silicone compound containing a (meth)acrylic group.

### (Comparative Example 4)

An adhesive composition and an adhesive tape were obtained in the same manner as in Example 1, except that 1 part by weight of a silicone oil having no functional group (KF-96-10cs, produced by Shin-Etsu Chemical Co., Ltd.) was mixed in place of the silicone compound containing a (meth)acrylic group.

### (Evaluation)

Adhesive compositions and adhesive tapes obtained in examples and comparative examples were evaluated using the following methods. Table 1 shows the results.

### (1) Evaluation of peelability

The obtained adhesive tape was used as a back grinding tape. The tape was applied to a side to be a circuit side of a 700 µm-thick silicon wafer (bare wafer) on which no circuit was formed. Then, the silicon wafer was thinned by grinding to a thickness of 50 µm, and heated at 200°C for 120 minutes as a whole. After the heating, a dicing tape was applied on the ground side of the silicon wafer and immobilized by adsorption. The wafer was then irradiated by an ultra-high pressure mercury lamp at 20mW/cm² for 150 seconds from the back grinding tape side. Then, the back grinding tape was peeled off.

Ten wafers in total were subjected to the above procedure, and each of the wafers was observed for cracking caused by stress due to peeling of the back grinding tape, damage of the circuit, and a residue of the adhesive on the circuit side.

Also, a 700 µm-thick silicon wafer (circuit wafer) on which a circuit having a difference in level of about 5 µm was formed was evaluated in the same manner.

### (2) Evaluation of IC chip contamination

The circuit silicon wafer (bare wafer) which was peeled off and transferred to a dicing tape without cracking in the above (1) was diced into 5 mm × 5 mm semiconductor chips. One hundred chips were randomly selected from the obtained chips and the area around the bump on each of the chips was observed using a microscope. The number of the semiconductor chips on which no surface abnormality such as resin residue and surface contamination was observed was calculated.

**[Table 1]**

| | Bleeding agent | | Gas generating agent | Inorganic filler | Evaluation of peelability (the number of wafer which was peeled off without cracking and circuit damage) | | Evaluation of contamination (the number of chip on which no residue was obsereved) |
|---|---|---|---|---|---|---|---|
| | Types | Amount (parts by weight) | | | Bare wafer | Circuit wafer | |
| Example 1 | Silicone compound containing (meth)acrvlic group | 1 | not added | not added | 10/10 | 10/10 | 98/100 |
| Example 2 | Silicone compound containing (meth)acrylic group | 1.5 | not added | not added | 10/10 | 10/10 | 99/100 |
| Example 3 | Silicone compound containing (meth)acrylic group | 2 | not added | not added | 10/10 | 10/10 | 99/100 |
| Example 4 | Silicone compound containing (meth)acrylic group | 8 | not added | not added | 10/10 | 10/10 | 96/100 |
| Example 5 | Silicone compound containing (meth)acrylic group | 10 | not added | not added | 10/10 | 10/10 | 95/100 |
| Example 6 | Silicone compound containing (meth)acrylic group | 20 | not added | not added | 10/10 | 10/10 | 100/100 |
| Example 7 | Silicone compound containing (meth)acrylic group | 30 | not added | not added | 10/10 | 10/10 | 98/100 |
| Example 8 | Silicone compound containing (meth)acrylic group | 2 | not added | not added | 10/10 | 10/10 | 99/100 |
| Example 9 | Silicone compound containing (meth)acrylic group | 2 | added | not added | 10/10 | 10/10 | 98/100 |
| Example 10 | Silicone compound containing (meth)acrylic group | 10 | added | not added | 10/10 | 10/10 | 100/100 |
| Example 11 | Silicone compound containing (meth)acrylic group | 10 | not added | added | 10/10 | 10/10 | 100/100 |
| Example 12 | Silicone compound containing (meth)acrvlic group | 10 | added | added | 10/10 | 10/10 | 100/100 |
| Example 13 | Silicone compound containing (meth)acrvlic group | 10 | added | added | 10/10 | 10/10 | 100/100 |
| Example 14 | Silicone compound containing (meth)acrylic group | 2 | not added | not added | 10/10 | 10/10 | 96/100 |
| Example 15 | Silicone compound containing (meth)acrylic group | 0.5 | not added | not added | 10/10 | 10/10 | 94/101 |
| Comparative Example 1 | - | - | not added | not added | 0/10 | 0/10 | 0/100 |
| Comparative Example 2 | - | - | added | not added | 0/10 | 0/10 | 0/100 |
| Comparative Example 3 | Acrylic oligomer | 1 | not added | not added | 2/10 | 0/10 | 0/100 |
| Comparative Example 4 | Silicone oil | 1 | not added | not added | 10/10 | 7/10 | 1/100 |

### INDUSTRIAL APPLICABILITY

The present invention can provide an adhesive composition which has high initial adhesion and can fix an adherend strongly, while can be easily peeled off by light irradiation even after undergoing a high-temperature process at 200°C or higher. The present invention also can provide an adhesive tape produced from the adhesive composition, and a wafer treatment method using the adhesive composition.

## Claims

1. An adhesive composition, comprising:
an adhesive component;
a photoinitiator; and
a silicone compound having a (meth)acrylic group on a siloxane backbone represented by the following formulae (I), (II), or (III): 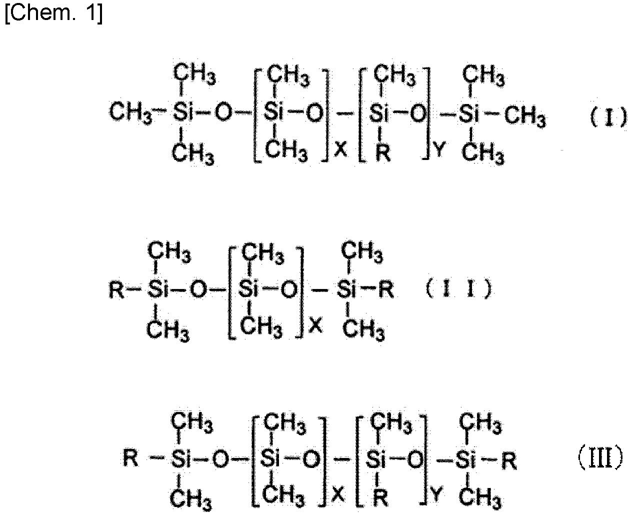
in the formulae, X and Y represent an integer from 0 to 1200, and R represents a functional group having a (meth)acrylic group,
wherein the adhesive component is a photocurable adhesive component, that contains an alkyl (meth)acrylate polymerizable polymer having a radically-polymerizable unsaturated bond in a molecule.

2. An adhesive tape, comprising an adhesive layer of the adhesive composition according to claim 1on at least one surface of a substrate.

3. A wafer treatment method, comprising:
a step of fixing a support plate in which a wafer is fixed to a support plate with the adhesive composition according to claim 1 or 2;
a step of treating the wafer in which the surface of the wafer fixed to the support plate is subjected to a treatment including heating at 200°C or higher; and
a step of peeling the support plate in which the wafer after the treatment is irradiated with light to cure the adhesive composition to peel off the support plate from the wafer.

## Patentansprüche

1. Klebstoffzusammensetzung, umfassend:
einen Klebstoffbestandteil,
einen Photoinitiator und
eine Silikonverbindung, aufweisend eine (Meth)acrylgruppe auf einer Siloxan-Hauptkette, die durch die folgenden Formeln (I), (II) oder (III) dargestellt ist: 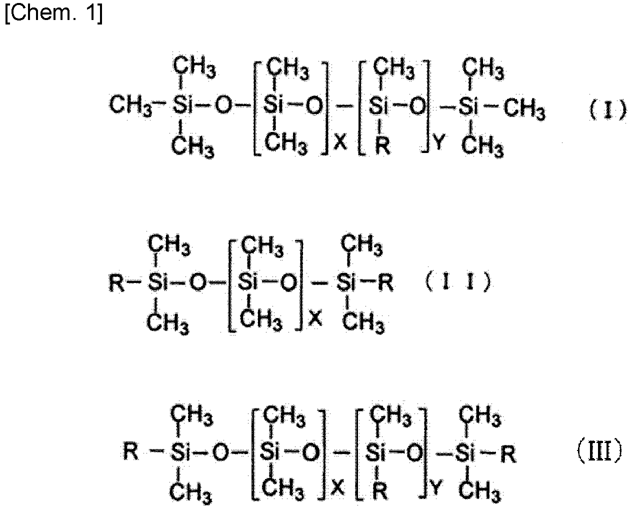
in den Formeln stehen X und Y für eine ganze Zahl von 0 bis 1200, und R steht für eine funktionelle Gruppe, die eine (Meth)acrylgruppe aufweist,
wobei der Klebstoffbestandteil ein photohärtbarer Klebstoffbestandteil ist, der ein polymerisierbares Alkyl-(Meth)acrylatpolymer mit einer radikalisch polymerisierbaren ungesättigten Bindung in einem Molekül enthält.

2. Klebeband, umfassend eine Klebstoffsicht der Klebstoffzusammensetzung nach Anspruch 1 auf wenigstens einer Oberfläche eines Substrats.

3. Waferbehandlungsverfahren, umfassend:
einen Schritt des Befestigens einer Trägerplatte, in dem ein Wafer mit der Klebstoffzusammensetzung nach Anspruch 1 oder 2 an einer Trägerplatte befestigt wird,
einen Schritt des Behandelns des Wafers, in dem die Oberfläche des an der Trägerplatte befestigten Wafers einer Behandlung unterzogen wird, die ein Erwärmen auf 200 °C oder höher umfasst, und
einen Schritt des Abziehens der Trägerplatte, in dem der Wafer nach der Behandlung mit Licht bestrahlt wird, um die Klebstoffzusammensetzung auszuhärten, um die Trägerplatte von dem Wafer abzuziehen.

## Revendications

1. Composition adhésive, comprenant :
un constituant adhésif ;
un photoinitiateur ; et
un composé de silicone ayant un groupe (méth)acrylique sur un squelette siloxane représenté par les formules (I), (II), ou (III) suivantes : 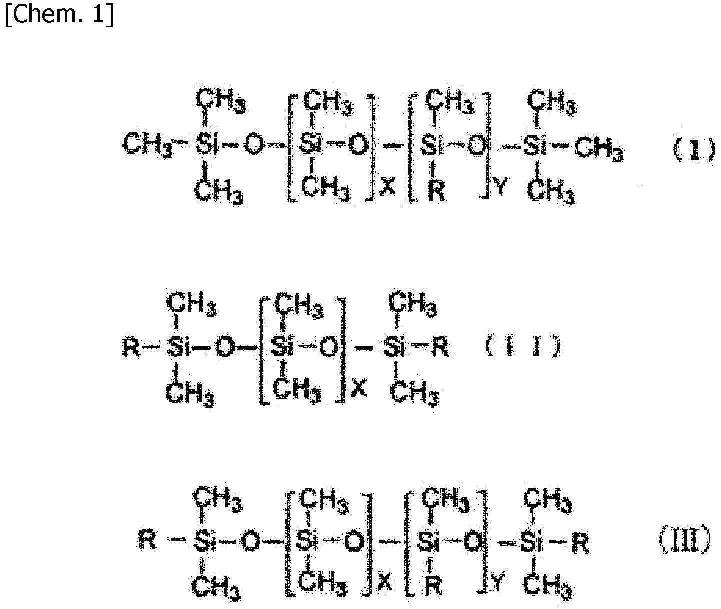
dans les formules, X et Y représentent un nombre entier de 0 à 1 200, et R représente un groupe fonctionnel présentant un groupe (méth)acrylique,
dans laquelle le constituant adhésif est un constituant adhésif photodurcissable, qui contient un polymère polymérisable de (méth)acrylate d'alkyle présentant une liaison insaturée radicalairement polymérisable dans une molécule.

2. Bande adhésive, comprenant une couche adhésive de la composition adhésive selon la revendication 1 sur au moins une surface d'un substrat.

3. Procédé de traitement de galette, comprenant :
une étape de fixation d'une plaque de support sur laquelle une galette est fixée à une plaque de support avec la composition adhésive selon la revendication 1 ou 2 ;
une étape de traitement de la galette dans laquelle la surface de la galette fixée à la plaque de support est soumise à un traitement incluant un chauffage à 200°C ou supérieur ; et
une étape de détachement de la plaque de support dans laquelle la galette après le traitement est irradiée avec de la lumière pour faire durcir la composition adhésive pour détacher la plaque de support de la galette.
